(19) Europäisches Patentamt European Patent Office Office européen des brevets

(11) **EP 4 439 597 A1**

(12) **EUROPEAN PATENT APPLICATION**

(43) Date of publication:
**02.10.2024 Bulletin 2024/40**

(21) Application number: **23165425.2**

(22) Date of filing: **30.03.2023**

(51) International Patent Classification (IPC):
**H01F 5/02** $^{(2006.01)}$  **H01F 38/30** $^{(2006.01)}$
**G01R 15/18** $^{(2006.01)}$

(52) Cooperative Patent Classification (CPC):
**H01F 5/02; G01R 15/181; H01F 38/30**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
• **HOZOI, Adrian**
  **68219 Mannheim (DE)**
• **PODZEMNY, Jaromir**
  **621 00 Brno (CZ)**

(74) Representative: **Maiwald GmbH**
**Engineering**
**Elisenhof**
**Elisenstrasse 3**
**80335 München (DE)**

(54) **COIL ELEMENT FOR A CURRENT SENSING DEVICE**

(57)    The present invention relates to 1 coil element (30) for a current sensing device, the coil element comprising: a winding body (10); and a length of wire (80); wherein the winding body has an outer surface around an axis of the winding body; wherein at least a portion of the length of wire is wound multiple times around the outer surface of the winding body in a generally circumferential direction with respect to the axis of the winding body; wherein a cross section of the outer surface perpendicular to the axis of the winding body has a substantially rectangular shape with two first sides opposite to one another and two second sides opposite to one another, and wherein a first axis of the cross section is equally spaced from the two first sides and has a dimension, a, and a second axis of the cross section perpendicular to the first axis of the cross section is equally spaced from the two second sides and has a dimension, b; wherein the cross section at corner regions (a2, a2', b2, b2') of the substantially rectangular shape has a first radius or range of first radii, rc; wherein the cross section at first inner regions (a1, a1') of the first sides adjacent to the corner regions has a second radius or range of second radii, ra; wherein the cross section at second inner regions (b1) of the second sides adjacent to the corner regions has a third radius or range of third radii, rb; wherein the cross section at middle regions (a0) of the first sides between the first inner regions of the first sides has a fourth radius or fourth range of radii, rao; wherein a ≥ b; wherein rc < ra < ∞; wherein rc < rb < ∞; wherein ra < ra0; and wherein rb < ra0; and wherein a dimension of the cross section parallel to the first axis from a second inner region of a second side to a second inner region of the opposite second side is less than the dimension, a; and wherein a dimension of the cross section parallel to the second axis from a first inner region of a first side to a first inner region of the opposite first side is less than the dimension, b.

Fig. 1

**Description**

FIELD OF THE INVENTION

The present invention relates to a coil element for a current sensing device, and to a current sensing device.

BACKGROUND OF THE INVENTION

An arrangement of coil elements can be configured to form an approximately closed path around a conductor to provide a measurement voltage, which is indicative of the current in the conductor.

A coil element comprises a winding segment with a plurality of wire turns applied on a winding body of a bobbin. Each turn generates a signal proportional to the area it encloses and depending on its position with respect to the conductor.

Bobbins are most efficiently produced by injection molding and a parting line along the winding body cannot be practically completely avoided. In practice, the parts of a mold tool are not perfectly aligned and matched leading to minor imperfections like steps and flash/burrs. Additional imperfections may arise if the injection point is placed on the winding body, which may be preferred in some cases for optimizing material flow. The imperfections can be attenuated in subsequent processing steps at additional cost.

The winding wire is typically very thin, often having a diameter between 0.02 mm and 0.18 mm, or between 0.04 mm and 0.12 mm. It is thus very sensitive to the winding parameters and to the quality of the winding body, which may affect the wire tension. Tension peaks caused during winding, or touching some edge under moderate tension, may even lead to breaking the wire. If the wire tension is too low during winding, the wire would have a loose and unstable position on the winding body.

Almost constant wire tension is achievable with a circular shape of the winding body providing a circular shaped winding contour, especially if the winding body is free of molding imperfections. Winding bodies with circular winding contour are described for example in US9664711 B2 and US9429595B2.

In practice, it is often the case that the available space is constrained and the winding contour provided by the winding body cannot be circular.

It is known to employ winding contours having a rectangular shape, however, the corners cause significant variations of the wire tension during winding. These variations limit both the winding speed and the winding quality because the wire can get stressed near the corners of the contour and become too loose along the straight segments. Rounding the corners is often not sufficient to smooth the wire tension and rounding the winding body significantly tending towards a circular shape for sides of the winding body to provide substantially circular shaped winding contours for parts of the winding body sacrifices a significant amount of the available space. Such solutions are described for example in US9494620B2.

There is a need to address these issues.

SUMMARY OF THE INVENTION

Therefore, it would be advantageous to have an improved coil element for a current sensing device.

The object of the present invention is solved with the subject matter of the independent claims, wherein further embodiments are incorporated in the dependent claims.

In a first aspect, there is provided a coil element for a current sensing device, the coil element comprising:

- a winding body; and
- a length of wire.

The winding body has an outer surface around an axis of the winding body. At least a portion of the length of wire is wound multiple times around the outer surface of the winding body in a generally circumferential direction with respect to the axis of the winding body. A cross section of the outer surface perpendicular to the axis of the winding body has a substantially rectangular shape with two first sides opposite to one another and two second sides opposite to one another. A first axis of the cross section is equally spaced from the two first sides and has a dimension, a. A second axis of the cross section perpendicular to the first axis of the cross section is equally spaced from the two second sides and has a dimension, b. The cross section at corner regions of the substantially rectangular shape has a first radius or range of first radii, rc. The cross section at first inner regions of the first sides adjacent to the corner regions has a second radius or range of second radii, ra. The cross section at second inner regions of the second sides adjacent to the corner regions has a third radius or range of third radii, rb. The cross section at middle regions of the first sides between the first inner regions of the first sides has a fourth radius or fourth range of radii, rao. The following applies:

-
$$a \geq b;$$

-
$$rc < ra < \infty;$$

-
$$rc < rb < \infty;$$

-
$$ra < ra0;$$

-
$$rb < ra0;$$

and

A dimension of the cross section parallel to the first axis from a second inner region of a second side to a second inner region of the opposite second side is less than the dimension, a. A dimension of the cross section parallel to the second axis from a first inner region of a first side to a first inner region of the opposite first side is less than the dimension, b.

In an example, a and b have lengths between 2mm and 40 mm, preferably between 3mm and 20 mm.

In an example, $b/15 < rc < b/3$.

In an example, $1.2a < ra < 3a$.

In an example, $1.2b < rb < 3b$.

In an example, $ra0 > 3a$, and optionally wherein $ra0 = \infty$.

In an example, the outer surface at the middle regions of the first sides between the first inner regions of the first sides has a length a0, and where the following applies:

$$0.2a < a0 < 0.75a.$$

In an example, each first inner region of the first sides is contiguous with a corner region.

In an example, each second inner region of the second sides is contiguous with two corner regions.

In an example, each middle region of the first sides is contiguous with two first inner regions of the first sides.

In a second aspect, there is provided a coil element for a current sensing device, the coil element comprising:

- a winding body; and
- a length of wire.

The winding body has an outer surface around an axis of the winding body. At least a portion of the length of wire is wound multiple times around the outer surface of the winding body in a generally circumferential direction with respect to the axis of the winding body. A cross section of the outer surface perpendicular to the axis of the winding body has a substantially rectangular shape with two first sides opposite to one another and two second sides opposite to one another. A first axis of the cross section is equally spaced from the two first sides and has a dimension, a. A second axis of the cross section perpendicular to the first axis of the cross section is equally spaced from the two second sides and has a dimension, b. The cross section at corner regions of the substantially rectangular shape has a first radius or range of first radii, rc. The cross section at first inner regions of the first sides adjacent to the corner regions has a second radius or range of second radii, ra. The cross section at second inner regions of the second sides adjacent to the corner regions has a third radius or range of third radii, rb. The cross section at middle regions of the first sides between the first inner regions of the first sides has a fourth radius or fourth range of radii, rao. The cross section at middle regions of the second sides between the second inner regions of the second sides has a fifth radius or fifth range of radii, rbo. The following applies:

- $$a \geq b;$$

- $$rc < ra < \infty;$$

- $$rc < rb < \infty;$$

- $$ra < ra0;$$

- $$rb < rb0;$$

and

A dimension of the cross section parallel to the first axis from a second inner region of a second side to a second inner region of the opposite second side is less than the dimension, a. A dimension of the cross section parallel to the second axis from a first inner region of a first side to a first inner region of the opposite first side is less than the dimension, b.

In an example, a and b have lengths between 2mm and 40 mm, preferably between 3mm and 20 mm.

In an example, $b/15 < rc < b/5$.

In an example, $1.4a < ra < 2.2a$.

In an example, $1.4b < rb < 2.2b$.

In an example, $ra0 > 5a$, and optionally wherein $ra0 = \infty$.

In an example, $rb0 > 5b$, and optionally wherein $rb0 = \infty$.

In an example, the outer surface at the middle regions of the first sides between the first inner regions of the first sides has a length a0, and where the following applies:

- wherein $0.3a < a0 < 0.7a$.

In an example, the outer surface at the middle regions of the second sides between the second inner regions of the second sides has a length b0, and where the following applies:

$$0.2b < b0 < 0.6a.$$

In an example, each first inner region of the first sides is contiguous with a corner region.

In an example, each second inner region of the second sides is contiguous with a corner region.

In an example, each middle region of the first sides is contiguous with two first inner regions of the first sides.

In an example, each middle region of the second sides is contiguous with two second inner regions of the second sides.

In a third aspect, there is provided a current sensing device comprising one or more coil elements according to the first aspect or any examples of the first aspect.

In an example, the current sensing device is configured as a Rogowski coil and comprises a plurality of coil elements.

In a fourth aspect, there is provided a current sensing device comprising one or more coil elements according to the second aspect or any examples of the second aspect.

In an example, the current sensing device is configured as a Rogowski coil and comprises a plurality of coil elements.

The above aspects and examples will become apparent from and be elucidated with reference to the embodiments described hereinafter.

BRIEF DESCRIPTION OF THE DRAWINGS

Exemplary embodiments will be described in the following with reference to the following drawings:

   Fig. 1 shows a cross-section through an exemplar winding body of an exemplar coil element with a winding contour in a substantially rectangular shape;

   Fig. 2 shows a cross-section through an exemplar winding body of an exemplar coil element with a winding contour in a substantially rectangular shape;

   Fig. 3 shows an exemplar current sensing device with a plurality of exemplar coil elements;

   Fig. 4A shows an end view of an exemplar coil element; and

   Fig. 4B shows a plan view, viewing downwards on the exemplar coil element of Fig. 4A.

DETAILED DESCRIPTION OF EMBODIMENTS

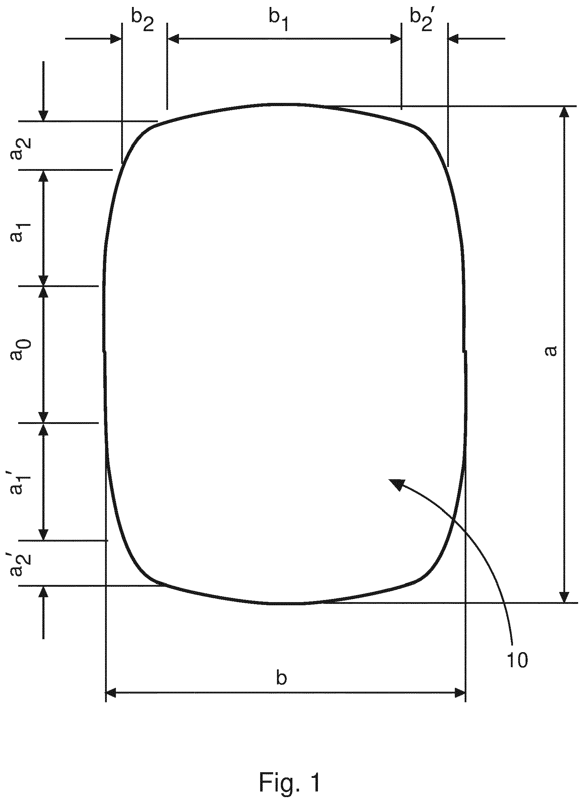

Figs. 1-4B relate to coil elements for a current sensing device and to current sensing devices having such coil elements.

In an example, a coil element 30 for a current sensing device comprises a winding body 10, and a length of wire 80. The winding body has an outer surface around an axis of the winding body. At least a portion of the length of wire is wound multiple times around the outer surface of the winding body in a generally circumferential direction with respect to the axis of the winding body. A cross section of the outer surface perpendicular to the axis of the winding body has a substantially rectangular shape with two first sides opposite to one another and two second sides opposite to one another. A first axis of the cross section is equally spaced from the two first sides and has a dimension, a. A second axis of the cross section perpendicular to the first axis of the cross section is equally spaced from the two second sides and has a dimension, b. The cross section at corner regions (a2, a2', b2, b2') of the substantially rectangular shape has a first radius or range of first radii, rc. The cross section at first inner regions a1, a1' of the first sides adjacent to the corner regions has a second radius or range of second radii, ra. The cross section at second inner regions b1 of the second sides adjacent to the corner regions has a third radius or range of third radii, rb. The cross section at middle regions a0 of the first sides between the first inner regions of the first sides has a fourth radius or fourth range of radii, rao. The following relationships apply:

- $$a \geq b;$$

- $$rc < ra < \infty;$$

- $$rc < rb < \infty;$$

- $$ra < ra0;$$

- $$rb < ra0;$$

   and

A dimension of the cross section parallel to the first axis from a second inner region of a second side to a second inner region of the opposite second side is less than the dimension, a. A dimension of the cross section parallel to the second axis from a first inner region of a first side to a first inner region of the opposite first side is less than the dimension, b.

It is to be noted that where it is described that a dimension of the cross section parallel to the first axis from a second inner region of a second side to a second inner region of the opposite second side is less than the dimension, a, the dimension can be equal at the intersection with the middle region (or even slightly larger in case of manufacturing deviations). Thus, there could be a slight bulge outwards in moving towards the corner region. Thus, it can be considered that the cross section parallel to the first axis from a second inner region of a second side to a second inner region of the opposite second side is predominantly less than the dimension, a.

Similarly, it is to be noted that where it is described that a dimension of the cross section parallel to the second axis from a first inner region of a first side to a first inner region of the opposite first side is predominantly less than the dimension, b, the dimension can be equal in the middle of the second inner regions. Thus, it can be considered that the dimension of the cross section parallel to the second axis from a first inner region of a first side to a first inner region of the opposite first side is predominantly less than the dimension, b.

In an example, a and b have lengths between 2mm and 40 mm, preferably between 3mm and 20 mm.

In an example, $b/15 < rc < b/3$.

In an example, $1.2a < ra < 3a$.

In an example, $1.2b < rb < 3b$.

In an example, $ra0 > 3a$, and optionally wherein $ra0 = \infty$.

In an example, the outer surface at the middle regions of the first sides between the first inner regions of the first sides has a length a0, and $0.2a < a0 < 0.75a$.

In an example, each first inner region of the first sides is contiguous with a corner region.

In an example, each second inner region of the second sides is contiguous with two corner regions.

In an example, each middle region of the first sides is contiguous with two first inner regions of the first sides.

Fig. 1 shows a cross section through a winding body relating to these examples, where the solid line is the outer perimeter that is a slice of the winding body and defines a winding contour, and where the centre of the winding body could be hollow, which saves material and can be used to insert a jig for supporting the winding body during the wire winding process. Thus, looking at Fig. 1, each wind of wire of the first winding layer follows the winding contour that is the solid line shown. As winding layers are wound around the winding body, they will be spaced very slightly outwards as they on top of one another.

A current sensing device can then comprise one or more coil elements as described above.

In an example, the current sensing device is configured as a Rogowski coil and comprises a plurality of coil elements.

In an example a coil element 30 for a current sensing device comprises a winding body 20, and a length of wire 80. Continuing with the example, the winding body has an outer surface around an axis of the winding body. At least a portion of the length of wire is wound multiple times around the outer surface of the winding body in a generally circumferential direction with respect to the axis of the winding body. A cross section of the outer surface perpendicular to the axis of the winding body has a substantially rectangular shape with two first sides opposite to one another and two second sides opposite to one another. A first axis of the cross section is equally spaced from the two first sides and has a dimension, a. A second axis of the cross section perpendicular to the first axis of the cross section is equally spaced from the two second sides and has a dimension, b. The cross section at corner regions a2, a2', b2, b2' of the substantially rectangular shape has a first radius or range of first radii, rc. The cross section at first inner regions a1, a1' of the first sides adjacent to the corner regions has a second radius or range of second radii, ra. The cross section at second inner regions (b1) of the second sides adjacent to the corner regions has a third radius or range of third radii, rb. The cross section at middle regions a0 of the first sides between the first inner regions of the first sides has a fourth radius or fourth range of radii, rao. The cross section at middle regions b0 of the second sides between the second inner regions of the second sides has a fifth radius or fifth range of radii, rbo. The following relationships apply:

- $$a \geq b;$$

- $$rc < ra < \infty;$$

- $$rc < rb < \infty;$$

- $$ra < ra0;$$

- $$rb < rb0;$$

  and

A dimension of the cross section parallel to the first axis from a second inner region of a second side to a second inner region of the opposite second side is less than the dimension, a. A dimension of the cross section parallel to the second axis from a first inner region of a first side to a first inner region of the opposite first side is less than the dimension, b.

It is to be noted that where it is described that a dimension of the cross section parallel to the first axis from a second inner region of a second side to a second inner region of the opposite second side is less than the dimension, a, the dimension can be equal at the intersection with the middle region (or even slightly larger in case of manufacturing deviations). Thus, there could be a slight bulge outwards in moving towards the corner region. Thus, it can be considered that cross section parallel to the first axis from a second inner region of a second side to a second inner region of the opposite second side is predominantly less than the dimension, a.

Similarly, it is to be noted that where it is described that a dimension of the cross section parallel to the second axis from a first inner region of a first side to a first inner region of the opposite first side is less than the dimension, b, the dimension can be equal in the middle of the second inner regions. Thus, it can be considered that the dimension of the cross section parallel to the second axis from a first inner region of a first side to a first inner region of the opposite first side is predominantly less than the dimension, b.

In an example, a and b have lengths between 2mm and 40 mm, preferably between 3mm and 20 mm.

In an example, $b/15 < rc < b/5$.

In an example, $1.4a < ra < 2.2a$.

In an example, $1.4b < rb < 2.2b$.

In an example, $ra0 > 5a$, and optionally wherein $ra0 = \infty$.

In an example, $rb0 > 5b$, and optionally wherein $rb0 = \infty$.

In an example, the outer surface at the middle regions of the first sides between the first inner regions of the first sides has a length a0, and $0.3a < a0 < 0.7a$.

In an example, the outer surface at the middle regions of the second sides between the second inner regions of the second sides has a length b0, and $0.2b < b0 < 0.6a$.

In an example, each first inner region of the first sides is contiguous with a corner region.

In an example, each second inner region of the second sides is contiguous with a corner region.

In an example, each middle region of the first sides is contiguous with two first inner regions of the first sides.

In an example, each middle region of the second sides is contiguous with two second inner regions of the second sides.

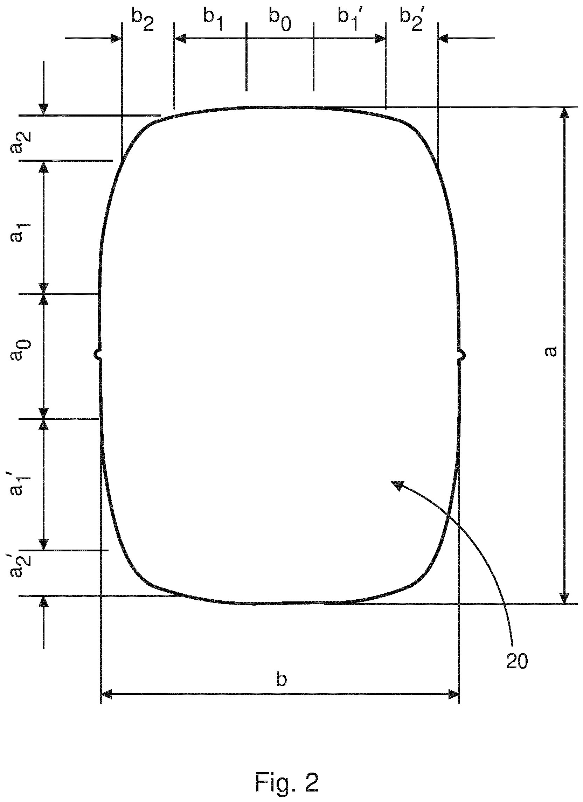

Fig. 2 shows a cross section through a winding body relating to these examples, where the solid line is the outer perimeter that is a slice of the winding body and defines a winding contour, and where the centre of the winding body could be hollow, which saves material and can be used to insert a jig for supporting the winding body during the wire winding process. Thus, looking at Fig. 2, each wind of wire of the first winding layer follows the winding contour that is the solid line shown. As winding layers are wound around the winding body, they will be spaced very slightly outwards as they on top of one another.

A current sensing device can then comprise one or more coil elements as described above.

In an example, the current sensing device is configured as a Rogowski coil and comprises a plurality of coil elements.

Thus, a new current sensing device has been developed for sensing an alternating current with compact size and low manufacturing cost. The device can operate according to the Rogowski coil principle and has at least a coil element provided with a winding segment applied on a new design of winding body. A plurality of coil elements can be mounted on a printed circuit board (PCB) substrate.

As described above a new winding body is provided for the coil element that has an improved winding contour. The winding contour has a shape approaching a rectangle and comprises multiple curvature portions at the corners and near the corners. The curvature portions are configured to maximize the area of the winding contour, to achieve mostly firm contact between the wire and the winding body, to minimize the wire stress, and to maximize the winding speed during manufacturing. The winding contour comprises approximately straight portions to reduce the contact between the wire and the winding body in regions with expectable manufacturing imperfections. The new developed winding body allows manufacturing a coil element having a winding with compact size, large number of wire turns, high accuracy, high reproducibility, high productivity, and low cost. Here, winding refers to the arrangement of the wire turns in the winding segment. Typically, several winding layers of wire turns are applied, e.g. between 2 and 12. The quality of the first winding layer is crucial as it impacts the quality of all subsequent winding layers. Winding defects in one winding layer propagate to the next layers and tend to multiply. The new design mitigates defects occurring whilst winding, and enables for high speed winding, with high accuracy and provides a coil element of a compact size and with a shape that enables it to be utilized effectively.

The compact size is achieved by maximizing the cross-sectional area of the winding body without exceeding a predetermined rectangular window and without compromising the winding quality. High winding quality is achieved by minimizing the variations of wire tension caused by the alternation of pronounced corners and pronounced flat regions during winding, facilitated by the new shape of the winding body having a specific shaped winding contour. The high winding quality allows using thin wire to achieve large number of wire turns and increasing the winding speed to achieve high productivity.

High winding accuracy is ensured by the good contact between the winding wire and the winding body which is provided along a predominant length of a wire turn due to the curvature portions of the winding contour of the new winding body design. The good contact also prevents minor displacements or deformations of the winding caused by mechanical stresses experienced during fabrication or during the lifetime of the device. High winding stability is thus also achieved.

High winding reproducibility is achieved by minimizing the impact of discontinuities caused by manufacturing imperfections in the bobbin, such like steps, flash/burrs, or injection point marks that may arise in molded parts. Here the bobbin is generally a molded part that has the winding body, and frequently flanges at either end, but a bobbin can have partial flanges or no flanges and then is in effect just a winding body, Approximately straight portions are provided on the winding body in the region of the discontinuities to reduce the pressure and the interaction between the discontinuities and the winding wire. Winding defects are mainly eliminated and high winding reproducibility is achieved at high winding speed.

Thus the new development enables to achieve predominantly stable contact between the winding wire and the winding body, and to locally reduce the contact pressure in regions which may comprise discontinuities caused by manufacturing imperfections.

High winding speed and tolerance to manufacturing imperfections are beneficial for reducing the cost of coil elements and of the current sensing device, and the compact size allows using the device in space constrained applications while the large number of turns enables high measurement sensitivity (or gain). The winding accuracy, stability, and reproducibility ensure high measurement performance of the device.

Continuing with Figs. 1-4B.

Fig. 1 shows a cross section through a winding body 10 where the solid line is a winding contour that has maximum dimensions given by $a$ and $b$. They are typically comprised between 2 and 40 mm, preferably between 3 and 20 mm. The winding contour has a shape approaching a rectangle and comprises moderate curvature portions at the corners, indicated by $a_2, b_2, a_2', b_2'$. The moderate curvature portions are provided with an approximately constant or varying radius $r_c$, being preferably in a range:

$$\min(a,b)/15 < r_c < \min(a,b)/3.$$

Preferably, the same limits also apply to $a_2, b_2, a_2', b_2'$.

Soft curvature portions are provided adjacent to the moderate curvature portions, indicated by $a_1, a_1', b_1$. The soft curvature portions are provided with approximately constant or varying radii $r_a$ and respectively $r_b$, preferably characterized by:

$$1.2a < r_a < 3a$$

$$1.2b < r_b < 3b.$$

The winding contour comprises approximately straight portions located in the center of opposing sides, indicated by $a_0$. The approximately straight portions are characterized by infinite or very high radius over noticeable length:

$$r_{a0} > 3a$$

$$0.2a < a_0 < 0.75a.$$

The bobbin or the winding body is typically made form one molded part. Minor discontinues like steps are shown in Fig. 1 which can be caused by a misalignment of the parts of the mold tool comprising the cavities defining the winding body. Minor discontinues like steps can also be caused by a mismatch of the parts of the mold tool. Thus, looking at Fig. 1 the approximately straight portions on the sides can frequently have minor discontinuities caused by a misalignment of parts of the mold tool used for injecting the winding body/bobbin.

The moderate curvature portions and the soft curvature portions are configured to maximize the area of a winding contour, which is constrained in a predetermined rectangular window, to limit the stress on the winding wire, and to achieve firm contact between the winding wire and the winding body. A soft curvature portion provides smooth transition between a moderate curvature portion and an approximately straight portion where the contact between the winding wire and the winding body is progressively weaker towards the center of the straight portion. Thus, the approximately straight portions are preferably provided where discontinuities may arise because of manufacturing imperfections, which can be better tolerated with a weaker contact between the wire and the winding body.

Fig. 2 shows a cross section through a winding body 20 where the solid line is a winding contour that has maximum dimensions given by $a$ and $b$. They are typically comprised between 2 and 40 mm, preferably between 3 and 20 mm. The winding contour has a shape approaching a rectangle and comprises moderate curvature portions at the corners, indicated by $a_2, b_2, a_2', b_2'$.

However, the winding body shown in Fig. 2 is a variation of that shown in Fig. 1, where in Fig. 2 the winding body has a shape such that the winding contour comprising straight portions on all sides, indicated by $a_0, b_0$. The straight portions on the shorter sides are characterized by

$$r_{b0} > 3b$$

$$b_0 < 0.7b.$$

Discontinuities caused by manufacturing imperfections like flash/burrs in injection molding can again be on the longer sides of the winding contour, approximately in the center.

In particular, high productivity and reliability are achieved at low cost if:

$$\min(a,b)/15 < r_c < \min(a,b)/5$$

$$1.4a < r_a < 2.2a$$

$$1.4b < r_b < 2.2b$$

$$0.3a < a_0 < 0.7a$$

$$0.2b < b_0 < 0.6b$$

$$r_{a0} > 5a, r_{b0} > 5b$$

The cost, stability, and accuracy benefits are maximized when employing a plurality of coil elements mounted on a PCB substrate.

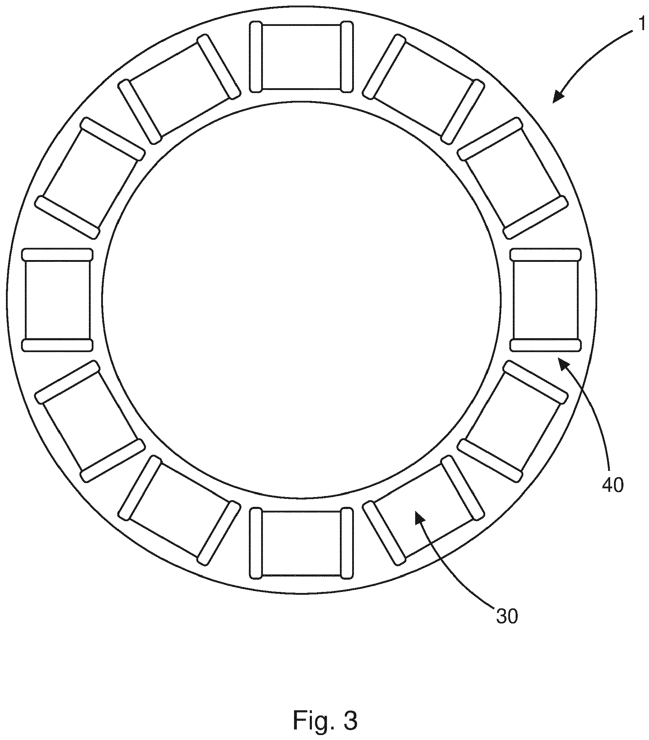

Fig. 3 shows a current sensing device 1 with 12 coil elements 30 mounted on a substrate 40, such as a PCB, and being uniformly distributed in a closed path around an opening provided in the substrate for a conductor carrying a current to be sensed.

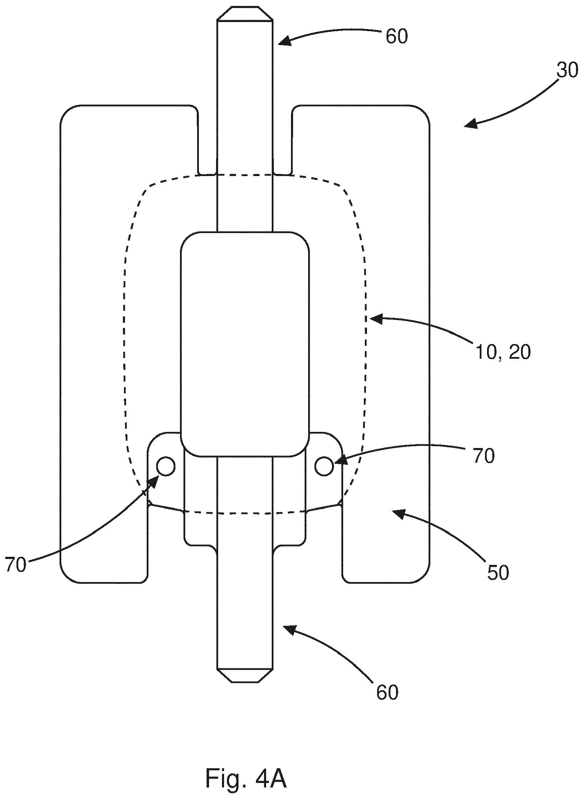

Each coil element 30 has locating pins 60 and the PCB 40 has mating retaining holes that are configured to precisely position the coil element to the PCB and to hold the coil element to the PCB with a retaining force. The locating pins 60 are shown in Figs. 4A-4B, where these are at the top and bottom of the coil element. In this arrangement, there are actually two PCBs 40 used for a current sensing device. The coil elements 30 connect to a lower PCB 40 via one of the locating pins 60 at the bottom of the coil element 30 and the coil elements 30 connect to an upper PCB 40 via a second one of the locating pins 60 at the top of the coil element. A coil element is (mechanically) positioned and attached/fixed to a lower PCB via locating pins, and it is electrically connected to the lower PCB via connecting pins, and there are two locating pins at the bottom, at least one at each (longitudinal) end of the coil element. Thus, looking at Fig. 3 there can be two parallel and annular shaped PCBs 40 with coil elements 30 between them. It is to be noted that the PCBs can be polygonal shaped, to match the "straight" sections, where coil elements are positioned.. The two PCBs 40 can be locked together with locking means, for example using locking pins. However, the locating pins 60 can both be at the bottom (or top) end of the coil element 30 and only one PCB 40 is required.

It is to be noted that an upper PCB is optional. Using only a lower PCB substrate is a basic arrangement which is sufficient in many applications, where coil elements with or without locating pins at the top can be employed. In this case, it is possible to use coil elements with locating pins at the top without inserting them in a substrate. The same coil element can be reused in alternative implementations of a device using a lower PCB and an upper PCB. Or a different type of substrate, or a housing or a part of a housing of the device can be employed instead of the upper PCB.

The locating pins at the top of the coil element are optional or may have a different appearance from the locating pins at the bottom of the coil element.

The winding body 10, 20 also has two holes 70 into which connecting pins can locate, that connect to either end of the wire 80 wound around the winding body 10, 20. A connecting pin comprises a segment inserted into the flange 50 of the coil element 30 and penetrating also the winding body 10, 20, a curved segment, and a segment directed to the PCB 40, preferably through a guiding channel.

Thus, continuing with Fig. 3 this shows a current sensing device 1 with 12 coil elements 30 mounted on a substrate 40 and being uniformly distributed in a closed path around an opening provided in the substrate for a conductor carrying a current to be sensed. Practical cost and accuracy tradeoffs are achieved using preferably between 6 and 32 coil elements 30. There can however, be many more coil elements mounted on the substrate 120 or even more. A coil element 30 comprises a winding segment applied on a winding body 10, 20 of a bobbin, where two flanges 50 delimit the winding segment, and two connecting pins. The substrate 40 is preferably a PCB provided with an electrically shielding plane like a ground plane at least on the side opposite to the coil elements 30 and with traces for sensing signals mainly on the side facing the coil elements 30. Each coil element is provided with locating pins 60 and the PCB substrate comprises mating retaining holes.

Fig. 4A shows a coil element 30 from a view from the outer side of a flange 50 of a bobbin having a winding body 10, 20 where the flange 40 is provided with locating pins 60 at the bottom and at the top. Thus, one PCB 40 is below coil element 30 and one PCB 40 is above the coil element 30 and the two locating pins 60 are located into the PCB. As explained previously, only one PCB can be utilized. The bobbin has a winding body 10, 20 with a winding contour as shown as a dashed line. Thus, into the page of Fig. 4A an axis runs down the centre of the winding body 10, 20 and in Fig. 3 this axis is locally in a circumferential direction of the annular part of the current sensing device 1. The winding body 10, 20 comprises two holes for inserting two respective connecting pins from the outer side of the flange for connecting to the wire 80. After connecting the ends of the winding wire 80 to the connecting pins, the connecting pins are curved in a direction to reach the PCB substrate, the direction being similar to that of the adjacent locating pin 60. The curved segment is configured to reduce the tension in the end of the winding wire 80 and to provide damping between the end of the winding wire 80 and a segment of the connecting pin connected to the PCB 40. A guiding channel like a groove is provided in the flange for a portion of the segment of a connecting pin connected to the PCB substrate.

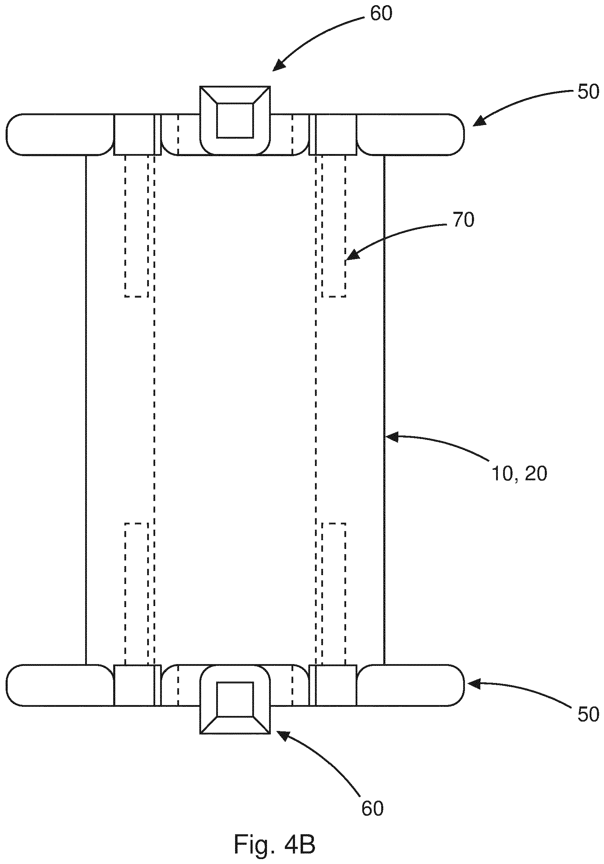

Fig 4B shows a view of coil element 30 with the bobbin and winding body 10, 20 in plan view, and actually shown from the bottom side and thus is a view from the bottom of the coil element 30 as shown in Fig, 4A. The thickness of a flange 50 is small at the lateral sides, and it is larger at the locating pin 60. Minimizing the thickness of flanges at least at the side facing the conductor allows maximizing the space occupied by the winding segments of the coil elements and thus improving the sensitivity and accuracy of the current sensing device.

The coil element 30 with the bobbin having a winding body 10, 20 from Fig. 4A and Fig 4B can be used in a current sensing device 1 where the coil elements 30 are clamped between two PCBs 40 and the coil elements 30 are provided with locating pins 60 engaged in retaining holes in both substrates. Using a second PCB 40 provides further improved stability and precision for the position of the coil elements 30. Holding pins with locking anchors are preferably provided to lock the two PCBs in a firm position. A locking anchor can be a head of the holding pin, or an enlarged portion of the holding pin, or a deformation of the holding pin, or a soldered locking anchor, or a combination of the above, or other practical implementation. The holding pins are preferably electrical pins compatible with common PCB assembly methods such as wave soldering. They can connect electrical signals between the PCBs, in particular an electrical shield potential provided on shielding planes of the PCBs. The locating pins 60 themselves can be utilized as the holding pins, or separate holding pins can be utilized.

Also, as discussed above the basic arrangement, is where there is only one substrate (that can be a PCB that provides for electrical connection or could be another type of substrate) is utilized, that is preferably a lower substrate. The substrate can be rigid or flexible, and where the second substrate is optional, and can again be in the form of a PCB substrate or another type of substrate.

A first PCB 40 comprises electrical connections for the coil elements 30 and connectivity means for interfacing the device to external apparatus. The second PCB 40 has a construction preferably identical to the first PCB, such that they are manufacturable in a same batch to result in simple and cheap production. The main differences between the two PCBs would be related to the electrical connections being assembled. However, as discussed above the coil elements 30 can be connected or mounted to a substrate 40 from the bottom (or top) end only, and there need only be one substrate 40, such as a PCB.

**Claims**

1. A coil element (30) for a current sensing device, the coil element comprising:

   - a winding body (10); and
   - a length of wire (80);

   wherein the winding body has an outer surface around an axis of the winding body;
   wherein at least a portion of the length of wire is wound multiple times around the outer surface of the winding body in a generally circumferential direction with respect to the axis of the winding body;
   wherein a cross section of the outer surface perpendicular to the axis of the winding body has a substantially rectangular shape with two first sides opposite to one another and two second sides opposite to one another, and wherein a first axis of the cross section is equally spaced from the two first sides and has a dimension, a, and a second axis of the cross section perpendicular to the first axis of the cross section is equally spaced from the two second sides and has a dimension, b;
   wherein the cross section at corner regions (a2, a2', b2, b2') of the substantially rectangular shape has a first radius or range of first radii, rc;
   wherein the cross section at first inner regions (a1, a1') of the first sides adjacent to the corner regions has a second radius or range of second radii, ra;
   wherein the cross section at second inner regions (b1) of the second sides adjacent to the corner regions has a third radius or range of third radii, rb;
   wherein the cross section at middle regions (a0) of the first sides between the first inner regions of the first sides has a fourth radius or fourth range of radii, rao;
   wherein $a \geq b$; wherein $rc < ra < \infty$; wherein $rc < rb < \infty$; wherein $ra < ra0$; and wherein $rb < ra0$; and
   wherein a dimension of the cross section parallel to the first axis from a second inner region of a second side to a second inner region of the opposite second side is less than the dimension, a; and
   wherein a dimension of the cross section parallel to the second axis from a first inner region of a first side to a first inner region of the opposite first side is less than the dimension, b.

2. Coil element according to claim 1, wherein a and b have lengths between 2mm and 40 mm, preferably between 3mm and 20 mm.

3. Coil element according to any of claims 1-2, wherein $b/15 < rc < b/3$; and/or wherein $1.2a < ra < 3a$; and/or wherein $1.2b < rb < 3b$; and/or wherein $ra0 > 3a$, and optionally wherein $ra0 = \infty$.

4. Coil element according to any of claims 1-3, wherein the outer surface at the middle regions of the first sides between the first inner regions of the first sides has a length a0, wherein $0.2a < a0 < 0.75a$.

5. Coil element according to any of claims 1-4, wherein each first inner region of the first sides is contiguous with a corner region.

**6.** Coil element according to any of claims 1-5, wherein each second inner region of the second sides is contiguous with two corner regions.

**7.** Coil element according to any of claims 1-6, wherein each middle region of the first sides is contiguous with two first inner regions of the first sides.

**8.** A coil element (30) for a current sensing device, the coil element comprising:

- a winding body (20); and
- a length of wire (80);

wherein the winding body has an outer surface around an axis of the winding body;
wherein at least a portion of the length of wire is wound multiple times around the outer surface of the winding body in a generally circumferential direction with respect to the axis of the winding body;
wherein a cross section of the outer surface perpendicular to the axis of the winding body has a substantially rectangular shape with two first sides opposite to one another and two second sides opposite to one another, and wherein a first axis of the cross section is equally spaced from the two first sides and has a dimension, a, and a second axis of the cross section perpendicular to the first axis of the cross section is equally spaced from the two second sides and has a dimension, b;
wherein the cross section at corner regions (a2, a2', b2, b2') of the substantially rectangular shape has a first radius or range of first radii, rc;
wherein the cross section at first inner regions (a1, a1') of the first sides adjacent to the corner regions has a second radius or range of second radii, ra;
wherein the cross section at second inner regions (b1) of the second sides adjacent to the corner regions has a third radius or range of third radii, rb;
wherein the cross section at middle regions (a0) of the first sides between the first inner regions of the first sides has a fourth radius or fourth range of radii, rao;
wherein the cross section at middle regions (b0) of the second sides between the second inner regions of the second sides has a fifth radius or fifth range of radii, rbo;
wherein $a \geq b$; wherein $rc < ra < \infty$; wherein $rc < rb < \infty$; wherein $ra < ra0$; and wherein $rb < rb0$; and
wherein a dimension of the cross section parallel to the first axis from a second inner region of a second side to a second inner region of the opposite second side is less than the dimension, a; and
wherein a dimension of the cross section parallel to the second axis from a first inner region of a first side to a first inner region of the opposite first side is less than the dimension, b.

**9.** Coil element according to claim 8, wherein a and b have lengths between 2mm and 40 mm, preferably between 3mm and 20 mm.

**10.** Coil element according to any of claims 8-9, wherein $b/15 < rc < b/5$; and/or wherein $1.4a < ra < 2.2a$; and/or wherein $1.4b < rb < 2.2b$; and/or wherein $ra0 > 5a$, and optionally wherein $ra0 = \infty$; and/or wherein $rb0 > 5b$, and optionally wherein $rb0 = \infty$.

**11.** Coil element according to any of claims 8-10, wherein the outer surface at the middle regions of the first sides between the first inner regions of the first sides has a length a0, wherein $0.3a < a0 < 0.7a$; and/or wherein the outer surface at the middle regions of the second sides between the second inner regions of the second sides has a length b0, wherein $0.2b < b0 < 0.6a$.

**12.** Coil element according to any of claims 8-11, wherein each first inner region of the first sides is contiguous with a corner region; and/or wherein each second inner region of the second sides is contiguous with a corner region.

**13.** Coil element according to any of claims 8-12, wherein each middle region of the first sides is contiguous with two first inner regions of the first sides; and/or wherein each middle region of the second sides is contiguous with two second inner regions of the second sides.

**14.** A current sensing device comprising one or more coil elements according to any of claims 1-7, or comprising one or more coil elements according to any of claims 8-13.

**15.** A current sensing device according to claim 14, wherein the current sensing device is configured as a Rogowski coil and comprises a plurality of coil elements according to any of claims 1-7 arranged in an annular configuration, or comprises a plurality of coil elements according to any of claims 8-13 arranged in an annular configuration.

Fig. 1

EP 4 439 597 A1

Fig. 2

12

Fig. 3

Fig. 4A

Fig. 4B

Europäisches
Patentamt

European
Patent Office

Office européen
des brevets

# EUROPEAN SEARCH REPORT

**Application Number**

EP 23 16 5425

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FR 2 783 346 B1 (SCHNEIDER ELECTRIC IND SA [FR]) 16 May 2003 (2003-05-16) * figures 4a,b * * corresponding description * ----- | 1-15 | INV. H01F5/02 H01F38/30 G01R15/18 |
| A | DE 197 25 897 C2 (SIEMENS AG [DE]) 2 November 2000 (2000-11-02) * figures 1-3 * * corresponding description * ----- | 1-15 | |
| A | US 2013/193987 A1 (KESLER JAMES R [US] ET AL) 1 August 2013 (2013-08-01) * figure 1I * * corresponding description * ----- | 1-15 | |
| A | US 9 429 595 B2 (CHAMARTI SUBRAMANYAM SATYASURYA [US]; BIETZ STEVEN LEE [US] ET AL.) 30 August 2016 (2016-08-30) * figures 5,6 * * corresponding description * ----- | 1-15 | |
| | | | **TECHNICAL FIELDS SEARCHED (IPC)** H01F G01R |

The present search report has been drawn up for all claims

| Place of search | Date of completion of the search | Examiner |
|---|---|---|
| Munich | 31 August 2023 | Weisser, Wolfgang |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 23 16 5425

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2023

| Patent document cited in search report | | Publication date | Patent family member(s) | | Publication date |
|---|---|---|---|---|---|
| FR 2783346 | B1 | 16-05-2003 | NONE | | |
| DE 19725897 | C2 | 02-11-2000 | NONE | | |
| US 2013193987 | A1 | 01-08-2013 | AU | 2012367317 A1 | 17-07-2014 |
| | | | BR | 112014017339 A2 | 13-06-2017 |
| | | | CA | 2859326 A1 | 01-08-2013 |
| | | | ES | 2535988 A2 | 19-05-2015 |
| | | | US | 2013193987 A1 | 01-08-2013 |
| | | | WO | 2013112190 A1 | 01-08-2013 |
| | | | ZA | 201404766 B | 23-12-2015 |
| US 9429595 | B2 | 30-08-2016 | CN | 102998507 A | 27-03-2013 |
| | | | EP | 2568300 A2 | 13-03-2013 |
| | | | JP | 6342605 B2 | 13-06-2018 |
| | | | JP | 2013061326 A | 04-04-2013 |
| | | | US | 2013063129 A1 | 14-03-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9664711 B2
- US 9429595 B2

- US 9494620 B2